Europäisches Patentamt

European Patent Office

Office européen des brevets

(19)

(11) **EP 1 422 763 A1**

(12) **DEMANDE DE BREVET EUROPEEN**

(43) Date de publication:
26.05.2004 Bulletin 2004/22

(51) Int Cl.⁷: **H01L 31/052**, H01L 31/045,
B64G 1/44

(21) Numéro de dépôt: 03292808.7

(22) Date de dépôt: 10.11.2003

(84) Etats contractants désignés:
**AT BE BG CH CY CZ DE DK EE ES FI FR GB GR
HU IE IT LI LU MC NL PT RO SE SI SK TR**
Etats d'extension désignés:
**AL LT LV MK**

(30) Priorité: 25.11.2002 FR 0214732

(71) Demandeur: **ALCATEL**
**75008 Paris (FR)**

(72) Inventeur: **Boulanger, Bernard**
**83600 Frejus (FR)**

(74) Mandataire: **Sciaux, Edmond et al**
**Compagnie Financière Alcatel**
**Département de Propriété Industrielle,**
**5, rue Noel Pons**
**92734 Nanterre Cedex (FR)**

(54) **Cellule solaire pour panneau de générateur solaire, panneau de générateur solaire et véhicule spatial**

(57)     Une cellule solaire pour un panneau (10,10') de générateur solaire.

Selon l'invention, la cellule est couplée à un réflecteur (70,71,700) de sorte que la cellule forme avec le réflecteur un composant élémentaire (20,21,20'), tandis que l'autre extrémité (E2,E2') demeure libre, les propriétés de flexibilité mécanique du réflecteur étant déterminées de manière à se maintenir dressé, dans une première position, où l'extrémité libre pointe vers l'espace extérieur en l'absence de pression verticale, définissant ainsi une première face du réflecteur dite supérieure (701,711) faisant face à l'espace extérieur alors que la face opposée dite inférieure (702,712) fait face au panneau, et de manière à, dans une seconde position, pouvoir présenter sa face supérieure orientée vers le plan du panneau en réponse à une pression verticale.

Application particulière aux véhicules spatiaux à panneaux solaires à concentration locale.

FIG_4a

## Description

La présente invention est relative, d'une manière générale, au domaine des cellules solaires, notamment pour applications spatiales. Elle concerne plus particulièrement une cellule solaire pour un panneau de générateur solaire, notamment pour véhicule spatial, comprenant au moins un réflecteur pour la réflexion du rayonnement solaire sur au moins une cellule photovoltaïque du panneau.

L'invention concerne également un panneau de générateur solaire et un véhicule spatial.

Un panneau de générateur solaire transporté dans un véhicule spatial, tel qu'un satellite, comprend en général :

- un panneau support d'un réseau de cellules photovoltaïques formant des chaîne de cellules ("strings" en anglais), transformant l'énergie solaire en énergie électrique,
- un réseau de réflecteurs qui concentrent les rayonnements solaires sur les précédents grâce à un revêtement aux propriétés adéquates.

De tels panneaux de générateur solaire peuvent être répartis selon des configurations très diverses. Il s'agit classiquement d'une succession longitudinale, parallèle à une direction s'éloignant du corps du véhicule spatial et autour de laquelle le générateur est destiné à tourner pour suivre le soleil. Toutefois, pour augmenter la puissance électrique disponible, il a été proposé de disposer, en plus des panneaux précédents, des panneaux supplémentaires latéraux. On connaît aussi des configurations dans lesquelles les panneaux sont disposés selon une direction transversale, c'est à dire selon une direction transversale à la direction longitudinale précitée selon laquelle s'étend l'étrier ou bras d'éloignement ("yoke" en anglais) qui relie le générateur au corps du véhicule spatial, et autour de laquelle le générateur est adapté à tourner pour suivre le soleil.

Lors du lancement, ce générateur est replié et ses panneaux sont empilés les uns sur les autres dans une configuration appelée configuration gerbée ou stockée.

La mise en service opérationnel du générateur, par exemple lorsque le véhicule est un satellite mis sur son orbite de service, impose de déplier l'empilement de panneaux : on parle alors de dégerbage.

Pour passer de la configuration gerbée à la configuration déployée, dans laquelle les panneaux solaires sont disposés sensiblement dans un même plan, les panneaux sont articulés deux à deux, soit au moyen d'articulations ayant des éléments adjacents articulés autour d'un axe de pivotement et solidarisés chacun à l'un de deux panneaux voisins, soit au moyen d'articulations reliant des bords parallèles de panneaux.

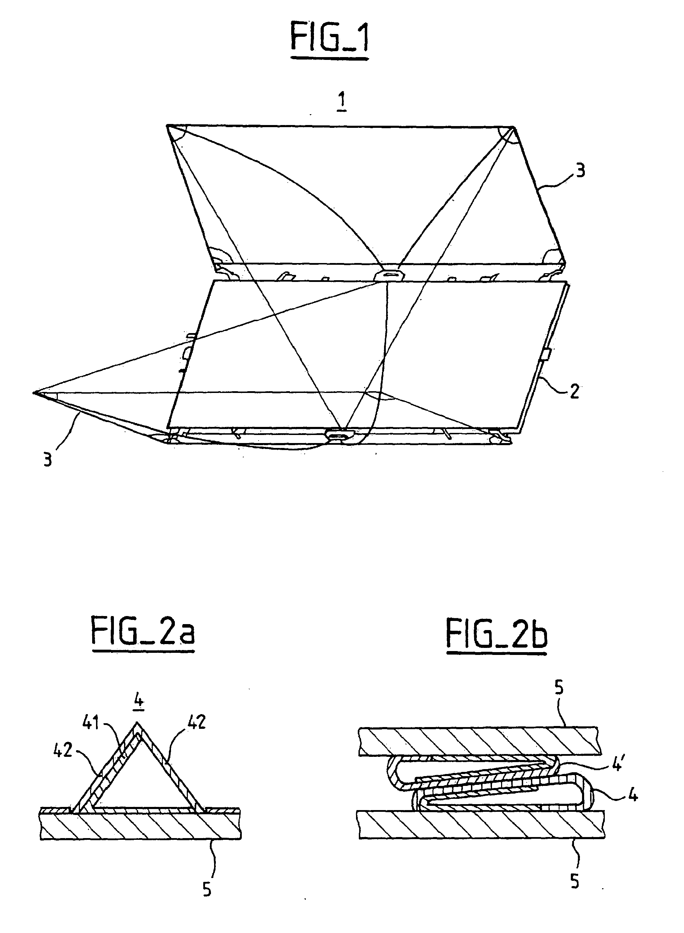

Concernant la méthode de concentration des rayonnements solaires, il a été proposé, dans un premier temps, tel qu'illustré sur la figure 1, un système 1, dit à auge, attrayant de part son apparente simplicité de mise en oeuvre. Celui-ci consiste à déployer de part et d'autre d'un panneau solaire 2 traditionnel, deux réflecteurs souples qui permettent, géométriquement, de doubler la surface collectrice de flux solaire. Cependant, ce système souffre de plusieurs inconvénients, notamment celui du modèle thermique adopté et surtout celui de présenter une limite technologique en termes de facteur de concentration et donc de puissance. En outre, il paraît difficile de maintenir les films réfléchissants en configuration optimale, des défauts de planéité ou de rigidité risquant d'apparaître. Un problème supplémentaire réside en ce que l'impact de défauts sur les réflecteurs (trous, plis) engendre une non-uniformité sur la surface active, provoquant alors l'apparition de phénomènes dits de "points chauds" : de fortes variations de courant peuvent surgir d'une chaîne de cellules à une autre, liées à la non-uniformité de distribution du flux solaire.

Afin de pallier ces différents inconvénients, il est apparu, dans un second temps, un nouveau concept de concentration. Selon ce concept, un panneau de générateur présente une succession alternée de chaînes de cellules et de réflecteurs. La concentration se réalise alors localement au niveau des cellules, conférant au système utilisé l'appellation usuellement admise de système à concentration locale.

Ce type de système à concentration locale est, par exemple, décrit dans le brevet US 6,177,627 et illustré sur les figures 2a et 2b de la présente demande. La figure 2a illustre un réflecteur 4 supporté par un panneau 5. Le réflecteur 4, de section triangulaire, est formé d'une partie 41 métallique et flexible, recouverte sur ses deux parois ouvertes vers l'espace d'une feuille 42 métallique flexible apte à réfléchir le rayonnement solaire. En position déployée, le réflecteur est naturellement tendue selon la figure 2a, la partie 41 étant formée d'un matériau se dressant naturellement dans sa position érigée. Par contre, lorsque les panneaux 5 sont dans leur configuration gerbée, tel que représenté sur la figure 2b, les panneaux en regard sont agencés de manière à minimiser l'espace existant entre eux, compressant au maximum les réflecteurs 4 et 4' en regard l'un de l'autre.

Cependant, dans les systèmes à concentration locale tel que celui présenté ci-dessus, une même chaîne de cellules solaires avec ses réflecteurs associés doit subir une phase d'adaptation (dite "matching" en anglais) avant sa mise en place sur le panneau, consistant à trier les cellules par rendement photoélectrique à un même pourcentage près (ceci de manière à ce qu'une cellule de rendement beaucoup plus faible que les autres ne limite pas le courant de la chaîne) ; cette phase de tri est réalisée sans les réflecteurs, de sorte que, quand les réflecteurs sont montés, ces derniers vont générer un « dismatching » (ou désadaptation) dans la chaine de l'ordre de la dispersion du coefficient de concentration des réflecteurs ; ceci a pour conséquence globale de perdre de la puissance.

En outre, selon l'art antérieur, lorsqu'une cellule tombe en panne, il est nécessaire de retirer les deux réflecteurs encadrant la cellule pour la remplacer et de nouveau placer les deux réflecteurs. Cette procédure de dépannage est également coûteuse en main d'oeuvre.

La présente invention a donc pour objectif de remédier aux problèmes exposés ci-dessus en proposant un nouveau concept de cellule solaire pour un panneau de générateur solaire, comportant au moins un réflecteur, qui permette une optimisation du rendement photoélectrique lors de la mise en place de la cellule sur le panneau.

A cet effet, l'invention a pour objet une cellule solaire pour un panneau de générateur solaire, caractérisé en ce qu'elle est couplée à un réflecteur pour la réflexion du rayonnement solaire sur la cellule, ce réflecteur étant sensiblement de même largeur que celle de contact avec la cellule et fixé à l'une de ses extrémités dans le sens de la hauteur à la cellule par des moyens de fixation de sorte que la cellule forme avec le réflecteur un composant élémentaire, tandis que l'autre extrémité demeure libre, les propriétés de flexibilité mécanique du réflecteur étant déterminées de manière à se maintenir dressé, dans une première position, où l'extrémité libre pointe vers l'espace extérieur en l'absence de pression verticale, définissant ainsi une première face du réflecteur dite supérieure faisant face à l'espace extérieur alors que la face opposée dite inférieure fait face au panneau, et de manière à, dans une seconde position, pouvoir présenter sa face supérieure orientée vers le plan du panneau en réponse à une pression verticale.

Ainsi, grâce à l'invention, il n'est nécessaire de procéder à l'étape d'adaptation qu'une fois le réflecteur assemblé avec la cellule. Pour cette raison, la dispersion des réflecteurs ne pénalise pas le rendement des cellules, au contraire de l'art antérieur.

De plus, un autre avantage de l'invention réside dans la simplification de remplacement des pièces en cas de panne d'une cellule. En effet, dans un tel cas de figure, il suffit de retirer le composant élémentaire défectueux pour le remplacer par un autre qui soit neuf. Cet avantage est considérable lorsqu'on le compare à la nécessité de retrait de deux rangées de réflecteurs et leur mise en place à la moindre panne.En outre, la surface fonctionnelle de réflexion du réflecteur, qui est la face supérieure, laquelle est pliée sur elle-même en configuration gerbée, est entièrement protégée de toute dégradation par action extérieure telle que des frottements avec des surfaces en regard.En outre, un autre avantage considérable de l'invention réside dans l'accessibilité à l'espace sous la lame flexible réfléchissante du réflecteur, ceci en cas de besoin de réparation du câblage situé dans cet espace. En effet, une fois que les cellules solaires et les réflecteurs du panneau sont installés, le câblage sous le toit des réflecteurs étant également mis en place, une série de tests est mis en oeuvre pour vérifier le fonctionnement de chacun des éléments du panneau. En cas de défauts de fonctionnement de l'un des câbles, il est obligatoire, en adoptant les réflecteurs à concentration locale de l'art antérieur, tel que décrit dans le brevet US 6,177,627, de retirer l'intégralité du réflecteur pour accéder au câblage associé. Grâce à l'invention, il n'est plus nécessaire de retirer le réflecteur. Il suffit d'écarter le réflecteur flexible pour que l'accessibilité ainsi souhaitée soit effective.

Selon un mode de réalisation de l'invention, la cellule repose sur la partie centrale du réflecteur, les extrémités de ce dernier étant conformées de manière à former deux sous-réflecteurs latéraux pour la cellule.

Selon un mode de réalisation de l'invention, le réflecteur est composé d'un matériau électriquement isolant, par exemple du Kapton™, et d'un renfort mécanique pour permettre ladite flexibilité, par exemple en Titane.

Selon un mode de réalisation de l'invention, les deux sous-réflecteurs sont fixés par des attaches électriquement isolantes à la cellule, cette dernière reposant sur un support électriquement isolant conformé de manière à permettre le soutien de la base des sous-réflecteurs lorsque ceux-ci sont déployés.

Selon un mode de réalisation de l'invention, les deux sous-réflecteurs sont formés d'un film réfléchissant.

Selon un mode de réalisation de l'invention, ledit réflecteur comporte une base sur laquelle repose la cellule, ladite base et les deux sous-réflecteurs formant une seule et même pièce en matériau électriquement isolant, les extrémités supérieures des sous-réflecteurs étant pourvues d'un film réfléchissant.

Selon un mode de réalisation de l'invention, selon une coupe dans le sens de la longueur de la chaîne de cellules à laquelle appartient la cellule, un support électriquement isolant de la cellule, dite courante, est conformé selon un profil à double inflexion de sorte qu'une première extrémité surbaissée de ce support puisse supporter une extrémité surélevée d'un support associé à une première cellule adjacente de la cellule courante et appartenant à ladite chaîne et l'autre seconde extrémité surélevée, destinée à supporter la cellule courante, puisse reposer sur une extrémité surbaissée d'un support associé à une seconde cellule adjacente de ladite cellule courante et appartenant à ladite chaîne, cet agencement entre supports adjacents permettant une entière isolation électrique des cellules d'une même chaîne avec le panneau de support de la chaîne.

Selon un mode de réalisation de l'invention, ledit réflecteur flexible présente des propriétés mécaniques telles qu'à l'équilibre de la première position, ladite face supérieure présente une concavité.

Selon un mode de réalisation de l'invention, ledit matériau flexible présente des propriétés mécaniques telles qu'à l'équilibre de la première position, chaque réflecteur forme un plan à l'exception de leur extrémité libre qui présente une courbure vers l'extérieur de manière à supporter la mise en contact lors de la phase de libération de la pression verticale.

Selon un mode de réalisation de l'invention, les surfaces des faces inférieures présentent un coefficient de frottement faible.

Selon un mode de réalisation de l'invention, les deux faces supérieures de chaque couple de sous-réflecteurs associées à une même cellule sont pliées sur elles-mêmes en se faisant face dans la seconde position.

L'invention a également pour objet un panneau de générateur solaire, caractérisé en ce qu'il comporte une cellule solaire selon l'invention.

L'invention a également pour objet un véhicule spatial, notamment satellite, caractérisé en ce qu'il comporte un panneau de générateur solaire selon l'invention.

D'autres caractéristiques et avantages de l'invention apparaîtront plus clairement à la lecture de la description suivante des exemples particuliers de réalisation en référence aux figures suivantes :

- la figure 1, déjà décrite, représente un système à panneau solaire et réflecteurs associés, selon un premier concept de l'art antérieur,
- les figures 2a et 2b, déjà décrites, représentent des réflecteurs selon un second concept de l'art antérieur,
- la figure 3 représente, schématiquement une vue en perspective d'un panneau de générateur solaire selon un mode de réalisation de l'invention,
- la figure 4a illustre une coupe, selon une section transversale, du panneau de la figure 3 en configuration dégerbée, la vue étant focalisée au niveau d'un couple de réflecteurs en regard, alors que la figure 4b illustre la même coupe que précédemment en configuration gerbée,
- la figure 5a représente l'évolution du facteur de concentration en fonction de l'angle d'incidence pour une configuration donnée,
- la figure 5b montre l'impact de la concavité des réflecteurs sur le facteur de concentration optique $C_{optique}$,
- la figure 5c montre l'effet conjoint de la concavité et de l'angle d'incidence des réflecteurs sur le facteur de concentration optique $C_{optique}$,
- la figure 5d montre la sensibilité du facteur de concentration optique $C_{optique}$ en fonction de l'angle d'incidence relié lui-même à la concavité,
- la figure 6 représente un autre mode de réalisation de couples cellule-réflecteur selon l'invention, selon une coupe transversal,
- la figure 7 représente une variante applicable tout aussi bien à l'un qu'à l'autre des modes de réalisation des figures 4a et 6, en y adaptant un moyen permettant de résoudre le problème de la totale isolation entre les cellules et le panneau.

Sur les figures suivantes, des éléments remplissant des fonctions identiques porteront les mêmes références.

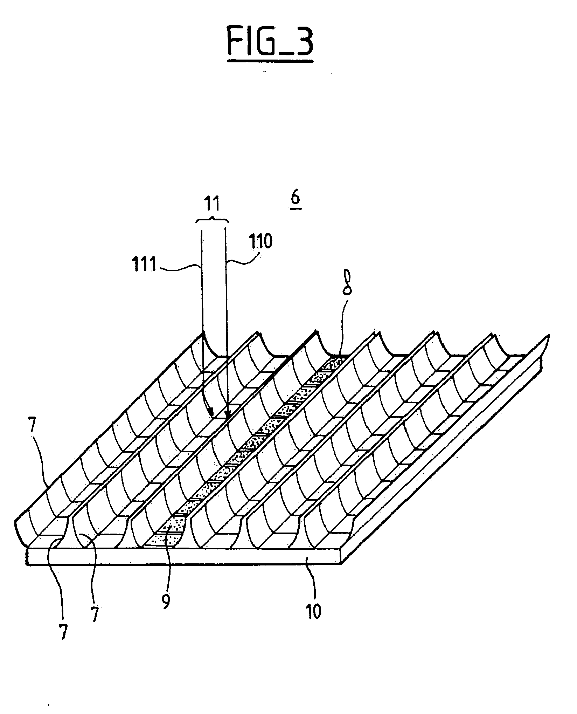

Sur la figure 3, il est représenté, schématiquement, une vue en perspective d'un panneau 6 de générateur solaire selon un mode de réalisation de l'invention.

Ce panneau 6 présente, sur sa face destinée à être orientée vers la source lumineuse, une succession alternée de composants réflecteurs 7 et de chaînes 8 de cellules 9 photovoltaiques (les cellules 9 étant figurées de façon hachurée dans la chaîne 8). On note que, dans ce mode de réalisation des réflecteurs, ceux-ci ont été choisis selon une configuration légèrement concaves. Comme il sera expliqué dans la suite, il peut être envisagé d'autres formes de réflecteurs. Les réflecteurs et les cellules sont supportés par un panneau 10 support.

Sur la figure 3, est représenté, sous forme de plusieurs flèches, un flux solaire 11 dont certains faisceaux 110 illuminent directement la cellule 9 alors que d'autres 111 atteignent la cellule suite à une réflexion sur un réflecteur 7.

En outre, on notera sur la figure 3 que les cellules et réflecteurs sont agencés suivant la longueur (c'est à dire parallèle à une direction s'éloignant du corps du satellite) des panneaux , ceci afin de ne pas être affectés par la variation saisonnière d'incidence du flux solaire.

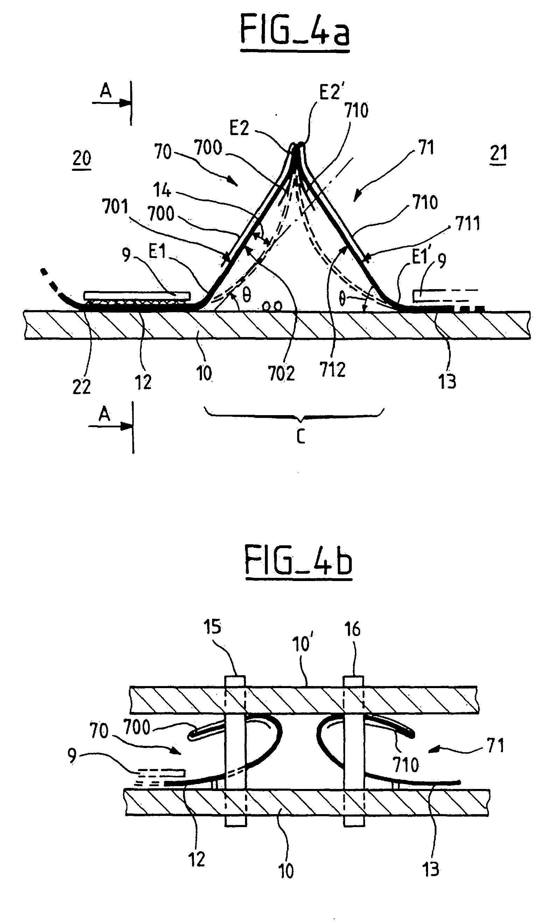

La figure 4a illustre une coupe selon une section transversale du panneau de la figure 3 en configuration dégerbée, la vue étant focalisée au niveau d'un couple C de réflecteurs 70, 71, alors que la figure 4b illustre la même coupe que précédemment en configuration gerbée.

Chaque réflecteur 70, 71 est composé de deux sous-réflecteurs latéraux 70, 71 comportant un matériau isolant électriquement et flexible. Chaque sous-réflecteur peut être, par exemple, un film de Kapton™, de 25μm doublé, soit 50μm entre cellules et substrat du panneau 10 de support. En outre, le Kapton™ comporte un renfort mécanique pour sa mise en forme lorsqu'il passe en mode dégerbé, par exemple 25μm de Titane. Bien entendu, tout autre matériau remplissant les conditions souhaitées de flexibilité et d'érectilité (en l'occurrence, tendance au redressement en l'absence de pression contraire) peut être envisagé. Le Kapton™ est recouvert sur les faces supérieures des sous-réflecteurs 70, 71, d'un film 700, 710 optiquement réfléchissant, du type de l'Argent, lui-même recouvert, de façon non représenté, d'un revêtement de protection. Cette caractéristique des sous-réflecteurs leur permet de réfléchir les rayons solaires incidents vers la cellule 9 en regard. Comme illustré, ce film 700, 710 dépasse leur extrémité libre E2, E2' et recouvre une partie des faces inférieures pour des raisons de maintien efficace sur les sous-réflecteurs.

A partir d'une configuration gerbée qui sera décrite dans la suite et consécutivement à une libération des panneaux, la configuration dégerbée des panneaux, telle que représentée sur la figure 4a, permet aux réflecteurs de se redresser naturellement dans leur position non contrainte. Comme illustré, les deux sous-réflecteurs associés à la cellule avec laquelle ils coopèrent, sont en regard l'un de l'autre. Chaque sous-réflecteur 70, 71 se prolonge au niveau de sa base E1, E1' respectivement par une base de support 12, 13 sur laquelle repose respectivement la cellule associée 9. La cellule est fixée à la base de support au moyen d'une colle isolante 22. Ainsi, le couple de sous-réflecteurs couplé par leur base commune et associé à leur cellule propre forme un composant élémentaire, tels que ceux référencés 20, 21. L'extrémité libre E2, E2' des sous-réflecteurs 70, 71 se retrouve naturellement en contact, exerçant une même pression l'une contre l'autre dans une position d'équilibre.

On notera que l'extrémité E2, E2' peut présenter une légère courbure vers l'extérieur de manière à supporter la mise en contact des deux sous-réflecteurs 70, 71 lors de la phase de libération de la pression verticale.

Selon une variante avantageuse de l'invention, illustrée en pointillés sur la figure 4a, le matériau flexible utilisé pour le sous-réflecteur présente des propriétés mécaniques telles qu'en position d'équilibre où les sous-réflecteurs en regard reposent l'un contre l'autre, les faces supérieures 701, 711 de chacune d'elles présentent une certaine concavité. Il va être expliqué dans la suite l'intérêt d'une telle disposition.

Comme mentionné ci-dessus, on soulignera déjà l'avantage résultant de la configuration en concentration locale comme résidant dans la diminution des effets de distorsion des réflecteurs sur la puissance fourni par le panneau solaire. Cela se traduit par un meilleur facteur de concentration global.

Dans le cas de la présente invention, le facteur de concentration Cgeometrique est fonction de l'angle θ d'inclinaison des réflecteurs par rapport au plan du panneau de support, ceci selon la relation :

$$C\text{géométrique} = 1 + 2\sin(2\theta - 90°).$$

La limite théorique de ce facteur est : Cgéométrique = 3.

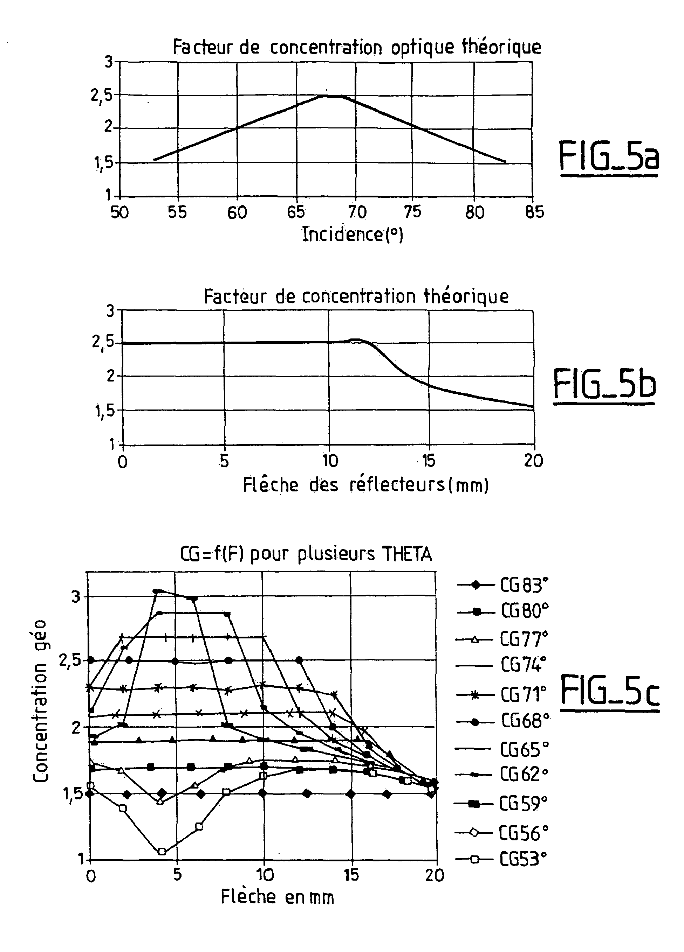

Dans le cas pratique où, les réflecteurs ont une longueur 2L par rapport à la cellule 9 de dimension L, tel que représenté sur la figure 4a, le facteur optique théorique obtenu par la méthode du "Ray-tracing", atteint un optimum égal à 2,5 pour une incidence correspondant à θ=68°, tel que l'on peut le constater sur la figure 5a illustrant le facteur de concentration optique théorique en fonction de l'incidence θ. Ceci présuppose que le rendement de réflectivité des réflecteurs soit de R=1 et que les réflecteurs soient parfaitement plans. La figure 5b représente l'effet de la présence d'une courbure ou concavité, illustrée par une double flèche 14 (figure 4a) s'exerçant sur une paroi de sous-réflecteur 70, 71. La dimension d'une telle flèche correspond à la distance entre la position plane du réflecteur et le point de la courbure le plus éloigné du sous-réflecteur. Une double flèche de plus de 10mm contribue à une diminution brutale du facteur de concentration optique.

Toute concavité des réflecteurs entraîne une variation des angles d'incidence des sous-réflecteurs. Dans le cas initial pratique de $C_{optique}$ =2,5, la figure 5c montre la variation du facteur de concentration pour différentes longueurs de flèches et par conséquent différents angles d'incidence. On s'aperçoit que l'optimum se situe pour des flèches voisines de 4mm ($C_{optique}$ >3 et supérieur au facteur de concentration initial 2,5). En fait, lorsque l'inclinaison des sous-réflecteurs diminue, la surface vue par le soleil de ces sous-réflecteurs augmente et l'énergie potentielle reçue augmente. Dans le cas de sous-réflecteurs plans, cette énergie n'est pas renvoyée vers la cellule mais lorsqu'ils présentent une courbure, cette énergie peut être renvoyée sur la cellule et ainsi augmenter le facteur de concentration.

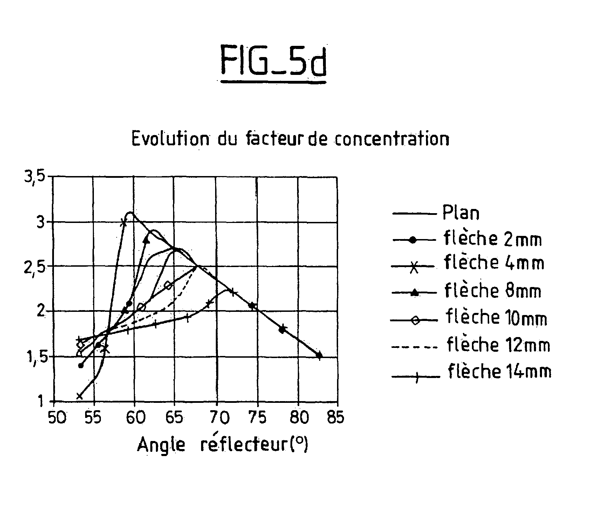

Pour une flèche de 4mm , $C_{optique}$ peut devenir supérieur au $C_{optique}$ initial mais devient très sensible à l'angle d'incidence θ comme montré sur la figure 5d.

Le facteur de concentration optique dépend du rendement R optique du matériau du film réfléchissant soit : $C_{optique}$ = 1+R($C_{optique\ R=1}$-1). Par exemple, pour R=1, $C_{optique}$ =2.5 et pour R=0.88, $C_{optique}$ = 2.32.

Typiquement, pour avoir un facteur de concentration optique stable à 10%, il faut une stabilité d'incidence de ± 4° et une flèche infèrieure à 12mm.

Il est à souligner qu'autant pour le mode de réalisation illustré sur la figure 4a que pour sa variante en pointillés, les surfaces inférieures 702, 712 pourront présenter un coefficient de frottement Φ tel que tg Φ< 0.25 par exemple avec du titane. Avec une telle disposition, lors de la libération des panneaux, si les deux sous-réflecteurs se retrouvent dans une position dissymétrique, les parties planes sans frottement des surfaces inférieures entraîneront automatiquement un mouvement d'ajustement des positions des sous-réflecteurs vers une position d'équilibre où la symétrie serait atteinte.

La figure 4b illustre la même coupe que la figure 4a dans la configuration gerbée de panneaux 10, 10'.

Le concept astucieux de l'invention prend également toute son ampleur dans la position qu'adoptent les sous-réflecteurs en configuration gerbée des panneaux. Au sol, les surfaces supérieures 701, 711 des sous-réflecteurs sont repliées sur elles-mêmes et en sens opposés, sous la pression du panneau supérieur 10'. Les panneaux 10, 10' sont maintenus les uns contre les autres au moyen de bandes 15, 16 de serrage.

Ainsi maintenus au sol jusqu'à leur libération, les films réfléchissants 700, 710 apposés sur les surfaces supérieures 701, 710 des sous-réflecteurs ne sont jamais en contact avec le panneau supérieur 10' ou un autre élément du panneau. Cette position permet au film réfléchissant de ne pas subir de dégradations par frottement.

Les panneaux étant repliés sur eux-mêmes, les bandes 15, 16 sont destinées à être libérées par la suite au sol. Les moyens de libération ne sont pas décrits dans la présente demande car connus en soi. Il arrive souvent que les séquences {déploiement de l'aile - repliement de l'aile} interviennent à plusieurs reprises, notamment lorsque plusieurs tests sont nécessaires. On comprend alors d'autant plus que les risques de dégradations des surfaces réfléchissantes en contact se multiplient et, en conséquence, que l'invention objet de la présente demande apporte une solution radicale à ce problème par rapport à l'art antérieur.

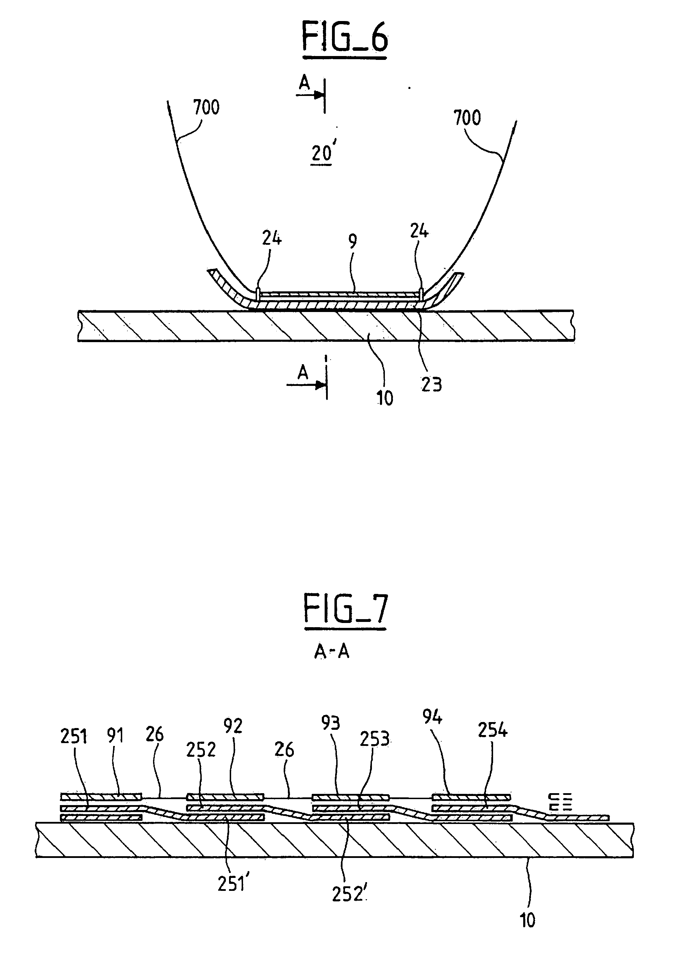

La figure 6 représente un autre mode de réalisation de composant élémentaire 20' cellule-réflecteur, selon une coupe transversale du composant.

Au contraire du précédent mode dans lequel la fonction d'isolation électrique entre la cellule et le panneau 10 était intégrée dans le réflecteur lui-même, cette fonction d'isolation est, dans le présent mode, découplée de la fonction de réflexion lumineuse et de conversion photoélectrique. En effet, le composant élémentaire 20' comporte un support 23 en matériau électriquement isolant du type Kapton™. Sur ce support 23 repose la cellule 9 collée au support 23 par une colle 22. Des sous-réflecteurs 700 latéraux sont fixés par des attaches 24 électriquement isolantes à la cellule 9. Par ailleurs, le support 23 est conformé sur ses bords de manière concave et surélevée vers le haut du composant, ceci permettant le soutien de la base des sous-réflecteurs en mode dégerbée.

En variante, il peut être envisagé de retirer le support 23 du composant élémentaire 20'. Ceci revient à dire que le support 23 fait partie du panneau et que le retrait d'un composant 20' pour son remplaçant ou pour sa réparation ne fait pas intervenir le support. Seuls sont retirés la cellule avec ses réflecteurs associés.

La figure 7 représente une variante applicable tout aussi bien à l'un qu'à l'autre des modes de réalisation des figures 4a et 6, en y adaptant un moyen permettant de résoudre le problème de la totale isolation entre les cellules et le panneau.

La figure 7 illustre une succession de cellules 91-94 d'une même chaîne 8. Chaque cellule repose sur un film respectif 251-254 de type Kapton™. Selon l'esprit de la présente astuce, chaque film 251-254 comporte une patte, telle que celles référencées 251', 252', conformée selon un profil à double inflexion de sorte qu'une première extrémité surbaissée de chaque patte supporte le film surélevé associé à la cellule adjacente, chaque film, lui-même surélevé reposant sur une patte surbaissée d'un film associé à l'autre cellule adjacente de la chaîne. Ainsi, cet agencement entre films permet une entière isolation électrique des cellules avec le panneau de support de celles-ci.

On notera bien sûr que les connexions électriques (souvent appelées interconnecteurs) reliant chaque cellule à ses voisines sont schématiquement figurées sous la référence 26.

Bien entendu, la description de cette dernière figure n'a fait volontairement intervenir que les éléments nécessaires à sa compréhension, et ceci de façon schématique. La mise en oeuvre des films 251-254 devra être adaptée en fonction des modes de réalisation. Ainsi, pour le mode de réalisation de la figure 4a, le film se placera entre la cellule 9 et la base de support 12 et la patte associée en position surbaissée se placera sous la base de support 12 de la cellule adjacente. Pour le mode de réalisation de la figure 6, le film se placera entre la cellule 9 et le support 23 et la patte associée se placera sous le support 23 de la cellule adjacente.

On notera que le film 700, 710 (Aluminium ou Argent ou autre matériau déposé optiquement très réfléchissant dans le visible et électriquement conducteur) est adapté pour offrir une propriété absorbante dans la gamme de fréquences infrarouges de manière à absorber sous forme de rayonnement infrarouge la chaleur emmagasinée suite à la réception du rayonnement solaire, et adapté pour offrir une propriété optique de réflexion dans la gamme des fréquences de la lumière visible.

Bien entendu, l'invention n'est pas limitée aux modes de réalisation décrits dans la présente demande.

## Revendications

**1.** Cellule solaire destiné à être posée sur un panneau (10,10') de générateur solaire, **caractérisé en ce qu'**elle est couplée à un réflecteur (70,71,700) pour la réflexion du rayonnement solaire sur la cellule (9), ce réflecteur, destiné également à être posé sur ledit panneau, étant sensiblement de même largeur que celle de contact avec la cellule et fixé à l'une de ses extrémités (E1) dans le sens de la hauteur à la cellule par des moyens de fixation (22,24) de sorte que la cellule forme avec le réflecteur un composant élémentaire (20,21,20'), tandis que l'autre extrémité (E2,E2') demeure libre, les propriétés de flexibilité mécanique du réflecteur étant déterminées de manière à se maintenir dressé, dans une première position, où l'extrémité libre pointe vers l'espace extérieur en l'absence de pression verticale, définissant ainsi une première face du réflecteur dite supérieure (701,711) faisant face à l'espace extérieur alors que la face opposée dite inférieure (702,712) fait face au panneau, et de manière à, dans une seconde position, pouvoir présenter sa face supérieure orientée vers le plan du panneau en réponse à une pression verticale.

**2.** Cellule selon la revendication 1, **caractérisée en ce que** la cellule repose sur la partie centrale du réflecteur, les extrémités de ce dernier étant conformées de manière à former deux sous-réflecteurs latéraux pour la cellule.

3. Cellule selon la revendication 2, **caractérisée en ce que** le réflecteur est composé d'un matériau électriquement isolant, par exemple du Kapton™, et d'un renfort mécanique pour permettre ladite flexibilité, par exemple en Titane.

4. Cellule selon la revendication 2, **caractérisée en ce que** les deux sous-réflecteurs (700) sont fixés par des attaches (24) électriquement isolantes à la cellule (9), cette dernière reposant sur un support (23) électriquement isolant conformé de manière à permettre le soutien de la base des sous-réflecteurs lorsque ceux-ci sont déployés.

5. Cellule selon la revendication 4, **caractérisée en ce que** les deux sous-réflecteurs sont formés d'un film (700) réfléchissant.

6. Cellule selon la revendication 2, **caractérisée en ce que** ledit réflecteur comporte une base (12) sur laquelle repose la cellule, ladite base et les deux sous-réflecteurs formant une seule et même pièce en matériau électriquement isolant, les extrémités supérieures des sous-réflecteurs étant pourvues d'un film réfléchissant (700,710).

7. Cellule selon l'une quelconque des revendications précédentes, **caractérisée en ce que**, selon une coupe (A-A) dans le sens de la longueur de la chaîne (8) de cellules à laquelle appartient la cellule, un support (251-254) électriquement isolant de la cellule, dite courante, est conformé selon un profil à double inflexion de sorte qu'une première extrémité surbaissée de ce support puisse supporter une extrémité surélevée d'un support associé à une première cellule adjacente de la cellule courante et appartenant à ladite chaîne et l'autre seconde extrémité surélevée, destinée à supporter la cellule courante, puisse reposer sur une extrémité surbaissée d'un support associé à une seconde cellule adjacente de ladite cellule courante et appartenant à ladite chaîne, cet agencement entre supports adjacents permettant une entière isolation électrique des cellules d'une même chaîne avec le panneau de support de la chaîne.

8. Cellule selon l'une quelconque des revendications précédentes, **caractérisée en ce que** ledit réflecteur flexible présente des propriétés mécaniques telles qu'à l'équilibre de la première position, ladite face supérieure (701, 711) présente une concavité (14).

9. Cellule selon l'une quelconque des revendications précédentes, **caractérisée en ce que** ledit matériau flexible présente des propriétés mécaniques telles qu'à l'équilibre de la première position, chaque réflecteur (70,71) forme un plan à l'exception de leur extrémité libre (E2) qui présente une courbure vers l'extérieur de manière à supporter la mise en contact lors de la phase de libération de la pression verticale.

10. Cellule selon l'une quelconque des revendications précédentes, **caractérisée en ce que** les surfaces des faces inférieures (702,712) présentent un coefficient de frottement faible.

11. Cellule selon l'une quelconque des revendications précédentes, **caractérisée en ce que** les deux faces supérieures de chaque couple de sous-réflecteurs associées à une même cellule sont pliées sur elles-mêmes en se faisant face dans la seconde position.

12. Panneau de générateur solaire, **caractérisé en ce qu'**il comporte une cellule solaire selon l'une des revendications précédentes.

13. Véhicule spatial, notamment satellite, **caractérisé en ce qu'**il comporte un panneau de générateur solaire selon la revendication 12.

# FIG_1

# FIG_2a

# FIG_2b

# FIG_3

## FIG_4a

## FIG_4b

Facteur de concentration optique théorique

FIG_5a

Incidence (°)

Facteur de concentration théorique

FIG_5b

Flêche des réflecteurs (mm)

CG=f(F) pour plusieurs THETA

FIG_5c

Concentration géo

Flèche en mm

- CG83°
- CG80°
- CG77°
- CG74°
- CG71°
- CG68°
- CG65°
- CG62°
- CG59°
- CG56°
- CG53°

# FIG_5d

Evolution du facteur de concentration

Plan
flèche 2mm
flèche 4mm
flèche 8mm
flèche 10mm
flèche 12mm
flèche 14mm

Angle réflecteur(°)

## FIG_6

## FIG_7

A-A

EP 1 422 763 A1

**Office européen des brevets**

**RAPPORT DE RECHERCHE EUROPEENNE**

Numéro de la demande

EP 03 29 2808

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 6 118 067 A (LASHLEY CHRISTOPHER M ET AL) 12 septembre 2000 (2000-09-12) * colonne 5, ligne 4 - colonne 6, ligne 21; revendications 1,3; figure 1 * | 1,5,8, 12,13 | H01L31/052 H01L31/045 B64G1/44 |
| A | US 6 188 012 B1 (RALPH EUGENE L) 13 février 2001 (2001-02-13) * colonne 3, ligne 27 - colonne 7, ligne 15; revendications 1,31,36; figures 1-4 * | 1,2,5,9, 11-13 | |
| A | EP 0 976 655 A (HUGHES ELECTRONICS CORP) 2 février 2000 (2000-02-02) * le document en entier * | 1,2,5,6, 8,11-13 | |
| A | M. ESKENAZI ET AL.: "The cellsaver concentrator for spacecraft solar arrays" 17TH EUROPEAN PHOTOVOLTAIC SOLAR ENERGY CONFERENCE, 22 - 26 octobre 2001, pages 2292-2295, XP001139938 MUNICH, DE * le document en entier * | 1,2,4-6, 9,11-13 | |
| A,D | US 6 177 627 B1 (MURPHY DAVE ET AL) 23 janvier 2001 (2001-01-23) * le document en entier * | 1,2,4-6, 9,11-13 | DOMAINES TECHNIQUES RECHERCHES (Int.Cl.7) H01L B64G |
| A | EP 1 174 342 A (UNIV LIEGE) 23 janvier 2002 (2002-01-23) * le document en entier * | 1,2,5, 11-13 | |
| A | US 5 520 747 A (MARKS GEOFFREY W) 28 mai 1996 (1996-05-28) | | |
| A | US 6 051 775 A (BROWN MICHAEL A ET AL) 18 avril 2000 (2000-04-18) | | |

Le présent rapport a été établi pour toutes les revendications

| Lieu de la recherche | Date d'achèvement de la recherche | Examinateur |
|---|---|---|
| BERLIN | 4 février 2004 | Visentin, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

14

ANNEXE AU RAPPORT DE RECHERCHE EUROPEENNE
RELATIF A LA DEMANDE DE BREVET EUROPEEN NO.

EP 03 29 2808

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-02-2004

| Document brevet cité au rapport de recherche | | Date de publication | Membre(s) de la famille de brevet(s) | | Date de publication |
|---|---|---|---|---|---|
| US 6118067 | A | 12-09-2000 | AU<br>WO | 2705300 A<br>0034124 A1 | 26-06-2000<br>15-06-2000 |
| US 6188012 | B1 | 13-02-2001 | AU<br>WO | 4303301 A<br>0138171 A2 | 04-06-2001<br>31-05-2001 |
| EP 0976655 | A | 02-02-2000 | EP | 0976655 A1 | 02-02-2000 |
| US 6177627 | B1 | 23-01-2001 | EP<br>WO | 1194956 A1<br>0079593 A1 | 10-04-2002<br>28-12-2000 |
| EP 1174342 | A | 23-01-2002 | EP<br>AU<br>WO<br>EP<br>US | 1174342 A1<br>8196601 A<br>0208058 A1<br>1301396 A1<br>2002007845 A1 | 23-01-2002<br>05-02-2002<br>31-01-2002<br>16-04-2003<br>24-01-2002 |
| US 5520747 | A | 28-05-1996 | AUCUN | | |
| US 6051775 | A | 18-04-2000 | AUCUN | | |

EPO FORM P0480

Pour tout renseignement concernant cette annexe : voir Journal Officiel de l'Office européen des brevets, No.12/82